# EUROPEAN PATENT APPLICATION

(11) **EP 4 451 817 A1**
(43) Date of publication of application: **23.10.2024**
(21) Application number: 23902521.6
(22) Date of filing: 01.12.2023
(51) Int. Cl.: H05K 7/20, H05K 7/14

(54) **ELECTRONIC DEVICE**

(30) Priority: 16.12.2022 CN 202223387665 U
(71) Applicant: Huawei Technologies Co., Ltd., Shenzhen, Guangdong 518129 (CN)
(72) Inventor: ZHAO, Yangyang, Shenzhen, Guangdong 518129 (CN); YANG, Qingzhi, Shenzhen, Guangdong 518129 (CN); ZOU, Liujun, Shenzhen, Guangdong 518129 (CN)
(74) Representative: Maiwald GmbH
(86) International application number: PCT/CN2023/135873
(87) International publication number: WO 2024/125324

(57) **Abstract**

This application relates to an electronic device. The electronic device includes a rear cover, a screen, a middle frame, and a heat dissipation assembly. The middle frame is located between the rear cover and the screen. The middle frame includes a fastened bottom wall and a fastened convex rib. The bottom wall is provided with a through hole. The convex rib is located on an outer side of the through hole. The convex rib protrudes in a thickness direction of the electronic device and towards a direction away from the bottom wall. The heat dissipation assembly is disposed on the convex rib. At least a part of the heat dissipation assembly is located in the through hole. The bottom wall of the middle frame is provided with the through hole. A bottom of the heat dissipation assembly is disposed inside the through hole, to form an embedded structure. This can reduce an overall thickness of the electronic device.

## Description

This application claims priority to Chinese Patent Application No. 202223387665.1, filed with the China National Intellectual Property Administration on December 16, 2022 and entitled "ELECTRONIC DEVICE", which is incorporated herein by reference in its entirety.

### TECHNICAL FIELD

This application relates to the field of electronic device heat dissipation technologies, and in particular, to an electronic device.

### BACKGROUND

With improvement of performance of an electronic device, heat generated by an internal electronic component of the electronic device is also obviously increased. If the heat cannot be dissipated in a timely manner, an excessively high temperature affects normal operation of the electronic component. Consequently, the electronic device cannot be used. Usually, a heat dissipation assembly is installed inside the electronic device. The heat dissipation assembly can achieve cooling effect in an active heat dissipation manner, to ensure normal operation of the electronic component.

In the conventional technology, the heat dissipation assembly is usually disposed between a rear cover and a screen, and a bottom of the heat dissipation assembly is stacked on a bottom wall of a middle frame. This structure causes an excessively large thickness of the electronic device, and is not conducive to reducing a thickness of the electronic device.

### SUMMARY

This application provides an electronic device, to reduce a thickness of the electronic device.

This application provides an electronic device. The electronic device includes a rear cover; a screen; a middle frame, where the middle frame is located between the rear cover and the screen, the middle frame includes a fastened bottom wall and a fastened convex rib, the bottom wall is provided with a through hole, the convex rib is located on an outer side of the through hole, and the convex rib protrudes in a thickness direction of the electronic device and towards a direction away from the bottom wall; and a heat dissipation assembly, where the heat dissipation assembly is disposed on the convex rib and at least a part of the heat dissipation assembly is located in the through hole.

In this solution, the bottom wall of the middle frame is provided with the through hole. Abottom of the heat dissipation assembly is disposed inside the through hole, to form an embedded structure. Compared with a structure in which the bottom of the heat dissipation assembly is directly stacked on the bottom wall in the conventional technology, the embedded structure can reduce an overall thickness of the electronic device. The convex rib protrudes in the thickness direction of the electronic device and towards a direction away from the bottom wall, so that local strength of the bottom wall can be enhanced and stability can be improved. In addition, the convex rib is located on the outer side of the through hole, and may be further configured to connect to the heat dissipation assembly, so that a location of the heat dissipation assembly can be stabilized during installation. In this way, the heat dissipation assembly can be prevented from shaking when the electronic device is used, ensuring installation stability of the heat dissipation assembly.

In a possible design, the electronic device further includes a reinforcement member. The reinforcement member is fastened at one end that is of the bottom wall and that is away from the convex rib. The reinforcement member covers the through hole.

In this solution, the reinforcement member is fastened to the bottom wall, and can cover the whole through hole. In this way, a local reinforcement function is implemented, and structural strength of the bottom wall around the through hole is improved. Therefore, overall structural strength of the middle frame is improved, ensuring reliability of the screen.

In a possible design, the heat dissipation assembly includes a housing and a fan. The housing includes an upper cover, a lower cover, and a side panel. The upper cover, the lower cover, and the side panel jointly enclose an accommodation space. The fan is disposed in the accommodation space. The upper cover is provided with an air inlet hole. The side panel is provided with an air outlet hole. The air inlet hole and the air outlet hole separately communicate with the accommodation space.

In this solution, the heat dissipation assembly uses an air cooling heat dissipation manner. Low-temperature cold air enters the accommodation space from the air inlet hole and in contact with the fan. A fan blade of the fan rotates to accelerate air flow and form an airflow. The airflow can flow from the air outlet hole to a heat generation electronic component, and exchange heat with the electronic component, to assist the electronic component in heat dissipation.

In a possible design, there is an air inlet channel between the upper cover and the rear cover. The air inlet channel communicates with the air inlet hole.

In this solution, there is a gap between the upper cover and the rear cover to form the air inlet channel. The external low-temperature cold air may flow from the air inlet channel to the air inlet hole. Compared with a manner in which the rear cover is provided with a hole as the air inlet channel in the conventional technology, this embodiment ensures integrity and structural strength of the rear cover are not damaged.

In a possible design, at least a part of the convex rib is disposed around the through hole. The side panel is fastened to the convex rib.

In this solution, a part of the convex rib is disposed around the through hole, to form a structure in which the convex rib surrounds the through hole in three sides. In this way, structural strength of the bottom wall around the through hole is enhanced, and a location of the air outlet hole is avoided, ensuring smooth air outlet of the heat dissipation assembly. At least a part of the side panel can extend in a direction of approaching the convex rib, and is stacked on an end portion of the convex rib. It is convenient for the convex rib to be fastened to the side panel, improving installation stability of the heat dissipation assembly.

In a possible design, the upper cover includes an upper cover diversion portion. The lower cover includes a lower cover diversion portion. The upper cover diversion portion and the lower cover diversion portion are disposed opposite to each other in the thickness direction of the electronic device.

In this solution, the upper cover diversion portion and the lower cover diversion portion are disposed opposite to each other in the thickness direction of the electronic device, so that a diversion channel can be formed. The diversion channel communicates with the air outlet hole, and is configured to guide an airflow flowing from the air outlet hole to the heat generation electronic component, ensuring smooth air outlet of the heat dissipation assembly.

In a possible design, the lower cover further includes a lower cover body. The lower cover diversion portion is connected to the lower cover body and is inclined relative to the lower cover body towards a direction close to the upper cover; and/or the upper cover further includes an upper cover body, and the upper cover diversion portion is connected to the upper cover body and is inclined relative to the upper cover body towards a direction away from the lower cover.

In this solution, the lower cover diversion portion is inclined relative to the lower cover body towards the direction close to the upper cover, and a slope structure is formed, so that the airflow climbs upward along the slope and then flows to the heat generation electronic component, to ensure smooth flow-out of the airflow in the accommodation space, and avoid unsmooth air outlet of the heat dissipation assembly due to block of the bottom wall; and/or, the upper cover diversion portion is inclined relative to the upper cover body towards the direction away from the lower cover, and a slope structure is also formed, so that an air outlet area of the heat dissipation assembly can be increased, to increase an air outlet volume, and further improve heat dissipation effect of the heat dissipation assembly.

In a possible design, there is an included angle α between the lower cover diversion portion and the lower cover body. The included angle α meets 120° ≤ α ≤ 170°.

In this solution, when the included angle α between the lower cover diversion portion and the lower cover body is 120° to 170°, it can be ensured that air outlet of the heat dissipation assembly is smooth and that the air volume is large enough.

In a possible design, the upper cover further includes an upper cover reinforcement portion. At least a part of the upper cover body is connected to the upper cover reinforcement portion. The upper cover reinforcement portion protrudes towards a direction away from the lower cover relative to the upper cover body.

In this solution, the upper cover reinforcement portion protrudes towards the direction away from the lower cover relative to the upper cover body. In this way, a local reinforcement function is implemented, structural strength of the upper cover body connected to the upper cover reinforcement portion is improved. Therefore, strength of the heat dissipation assembly is further improved, improving a pressing resistance capability of the heat dissipation assembly.

In a possible design, connection portions are disposed on the upper cover body. The connection portions are connected to the upper cover reinforcement portion. In a width direction of the heat dissipation assembly, the connection portions are disposed at two ends of the upper cover body. The two connection portions are separately fastened to the convex rib.

In this solution, the two connection portions are separately fastened to the convex rib in the width direction of the heat dissipation assembly. This can further improve installation stability of the heat dissipation assembly. The connection portions are connected to the upper cover reinforcement portion. The connection portions are connected to the convex rib located on two sides of the heat dissipation assembly to form an annular reinforcement structure as a whole. This can further implement a reinforcement function, and improve structural strength of the middle frame. In addition, force applied to the convex rib can be more evenly distributed, improving structural stability of the convex rib.

In a possible design, the electronic device further includes a flexible circuit board. One end that is of the lower cover and that is away from the fan is provided with a groove. At least a part of the flexible circuit board is disposed in the groove.

In this solution, one end that is of the lower cover and that is away from the fan may be provided with the groove, and then the flexible circuit board is disposed in the groove, that is, the flexible circuit board is embedded in the bottom wall of the lower cover. Compared with a solution in which the flexible circuit board is directly attached to the bottom wall of the lower cover in the conventional technology, this solution can further reduce a thickness of the electronic device, and helps to implement lightness and thinness of the electronic device.

It should be understood that the foregoing general descriptions and the following detailed descriptions are merely examples, and cannot limit this application.

### BRIEF DESCRIPTION OF DRAWINGS

FIG. 1 is a sectional view of an electronic device according to this application;
FIG. 2 is a sectional view of the electronic device in FIG. 1 from another view angle; and
FIG. 3 is a top view of an internal structure of the electronic device in FIG. 1.

### Reference numerals:

1: rear cover;
   10: air inlet channel;
2: screen;
3: middle frame;
   31: bottom wall;
      311: through hole;
   32: convex rib;
4: heat dissipation assembly;
   41: fan;
   42: upper cover;
      421: air inlet hole;
      422: upper cover diversion portion;
      423: upper cover body;
         423a: connection portion;
      424: upper cover reinforcement portion;
   43: lower cover;
      431: lower cover diversion portion;
      432: lower cover body;
   44: side panel;
      441: air outlet hole;
   45: accommodation space;
5: reinforcement member;
   51: glue;
6: flexible circuit board;
7: fastener.

The accompanying drawings herein are incorporated into this specification and constitute a part of this specification, show embodiments conforming to this application, and are used, together with this specification, to explain the principles of this application.

### DESCRIPTION OF EMBODIMENTS

For ease of understanding technical solutions of this application, the following describes embodiments of this application in detail with reference to the accompanying drawings.

In a specific embodiment, the following further describes this application in detail with reference to specific embodiments and the accompanying drawings.

Heat dissipation manners of an electronic device are classified into two types of active heat dissipation and passive heat dissipation. The passive heat dissipation is mainly performed in a manner in which a heat source directly contacts a medium such as air. Currently, because performance of the electronic device is continuously improved, heat generated by an internal electronic component of the electronic device gradually increases, and the passive heat dissipation manner cannot meet a heat dissipation requirement of the electronic device. Therefore, a heat dissipation assembly is usually disposed in a current electronic device, and the heat dissipation assembly dissipates heat in the active heat dissipation manner. Generally, the electronic device includes a screen, a rear cover, and a middle frame located between the screen and the rear cover. The heat dissipation assembly is disposed on the middle frame, and a bottom of the heat dissipation assembly is directly stacked on a bottom wall of the middle frame. However, this structure has a problem of a relatively large thickness, and causes an excessively large thickness of the electronic device, which does not comply with a current development trend of a low thickness of the electronic device.

To resolve this technical problem, an embodiment of this application provides an electronic device. The electronic device may be a mobile phone, a tablet computer, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a wearable device, a vehicle-mounted device, a smart home device, and/or a smart city device. A specific type of the electronic device is not limited in this embodiment of this application.

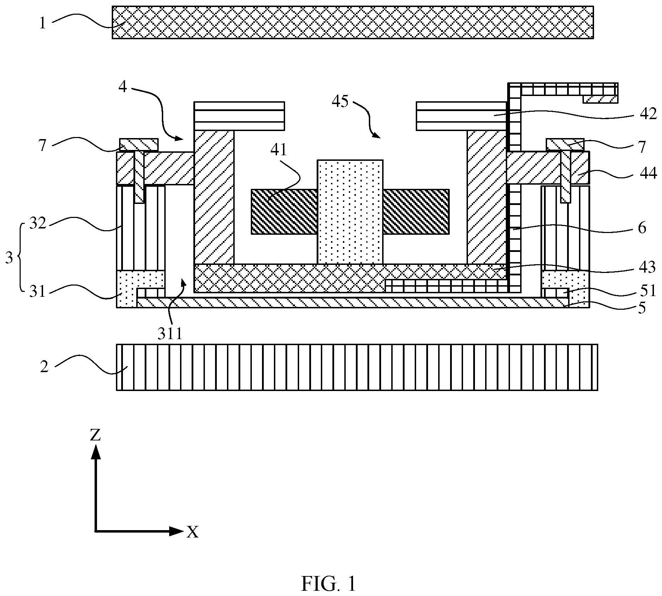

As shown in FIG. 1, the electronic device includes a rear cover 1, a screen 2, a middle frame 3, and a heat dissipation assembly 4. The middle frame 3 is located between the rear cover 1 and the screen 2. The middle frame 3 includes a fastened bottom wall 31 and a fastened convex rib 32. The bottom wall 31 is provided with a through hole 311. The convex rib 32 is located on an outer side of the through hole 311. The convex rib 32 protrudes in a thickness direction Z of the electronic device and towards a direction away from the bottom wall 31. The heat dissipation assembly 4 is disposed on the convex rib 32. At least a part of the heat dissipation assembly 4 is located in the through hole 311.

The middle frame 3 is mainly configured to install various electronic components of the electronic device. The heat dissipation assembly 4 is configured to assist heat dissipation of a heat generation electronic component. The bottom wall 31 of the middle frame 3 is provided with a through hole 311. A bottom of the heat dissipation assembly 4 is disposed inside the through hole 311, to form an embedded structure. Compared with a structure in which the bottom of the heat dissipation assembly 4 is directly stacked on the bottom wall 31 in the conventional technology, the embedded structure can reduce an overall thickness of the electronic device. As shown in FIG. 1, the convex rib 32 protrudes in the thickness direction Z of the electronic device and towards a direction away from the bottom wall 31, so that local strength of the bottom wall 31 can be enhanced and stability can be improved. In addition, the convex rib 32 is located on the outer side of the through hole 311, and may be further configured to connect to the heat dissipation assembly 4, so that a location of the heat dissipation assembly 4 can be stabilized during installation. In this way, the heat dissipation assembly 4 can be prevented from shaking when the electronic device is used, ensuring installation stability of the heat dissipation assembly 4.

The bottom wall 31 and the convex rib 32 may be of an integral structure or a split structure. This is not limited in this embodiment.

It should be noted that, to reduce damage caused by the through hole 311 to the structural strength of the middle frame 3 as far as possible, an area of the through hole 311 should not be excessively large, and should be slightly greater than an area of the heat dissipation assembly 4.

In a specific embodiment, as shown in FIG. 1, the electronic device provided in this embodiment of this application further includes a reinforcement member 5. The reinforcement member 5 is fastened to an end that is of the bottom wall 31 and that is away from the convex rib 32. The reinforcement member 5 covers the through hole 311.

The middle frame 3 provides support and protection for the screen 2. When the through hole 311 is disposed on the bottom wall 31, stress concentration is easily generated on the bottom wall 31 around the through hole 311. A decrease in a bearing area also causes a decrease in structural strength of the middle frame 3, affecting reliability of the screen 2. Therefore, the reinforcement member 5 needs to be disposed to perform hole reinforcement on the middle frame 3. As shown in FIG. 1, the reinforcement member 5 is fastened to the bottom wall 31, and can cover the whole through hole 311. In this way, a local reinforcement function is implemented, and structural strength of the bottom wall 31 around the through hole 311 is improved. Therefore, overall structural strength of the middle frame 3 is improved, ensuring reliability of the screen 2.

The reinforcement member 5 may be made of a material with relatively high structural strength and not easy to deform. Specifically, a material such as copper, aluminum, titanium, or stainless steel may be used. This is not limited in this embodiment. A thickness of the reinforcement member 5 may be 0.1 mm to 0.2 mm, to ensure that structural strength of the bottom wall 31 is effectively improved. The thickness may be specifically 0.1 m, 0.12 mm, 0.15 mm, or 0.2 mm, or may be another value within the foregoing range. This is not limited herein.

In addition, the reinforcement member 5 may be fastened to the bottom wall 31 in a bonding manner. Specifically, as shown in FIG. 1, a mounting groove may be provided on the bottom wall 31, glue 51 is applied in the mounting groove, and then the reinforcement member 5 is placed in the mounting groove to complete bonding.

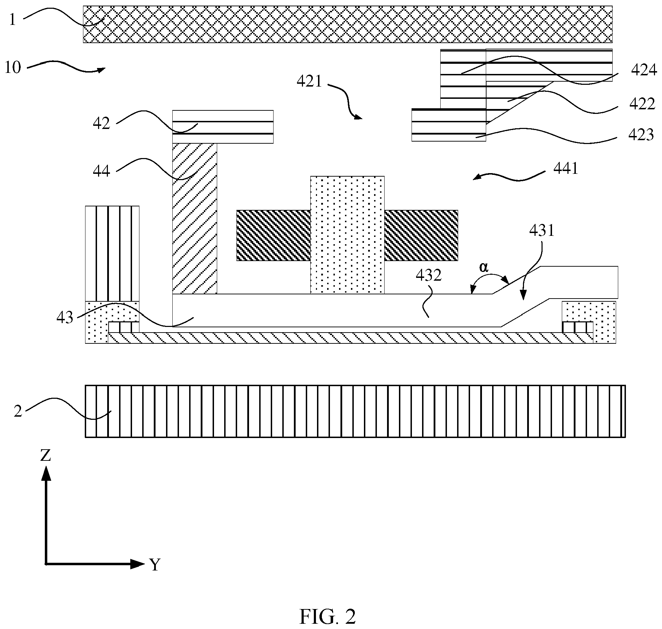

In a specific embodiment, as shown in FIG. 1 and FIG. 2, the heat dissipation assembly 4 includes a housing and a fan 41. The housing includes an upper cover 42, a lower cover 43, and a side panel 44. The upper cover 42, the lower cover 43, and the side panel 44 jointly enclose an accommodation space 45. The fan 41 is disposed in the accommodation space 45. The upper cover 42 is provided with an air inlet hole 421. The side panel 44 is provided with an air outlet hole 441. The air inlet hole 421 and the air outlet hole 441 separately communicate with the accommodation space 45.

In this embodiment, the heat dissipation assembly 4 uses an air cooling manner. Low-temperature cold air enters the accommodation space 45 from the air inlet hole 421 and in contact with the fan 41. A fan blade of the fan 41 rotates to accelerate air flow and form an airflow. The airflow can flow from the air outlet hole 441 to a heat generation electronic component, and exchange heat with the electronic component, to assist the electronic component in heat dissipation.

Specifically, refer to FIG. 1 and FIG. 2. The side panel 44 is not disposed around the fan 41, but uses a structure of surrounding the fan 41 in three sides. This can increase an area of the air outlet hole 441, and ensure that air volume flowing from the accommodation space 45 to the heat generation electronic component is large enough, improving heat dissipation effect of the heat dissipation assembly 4.

In addition, a quantity of fans 41 is not limited in this embodiment. When a heat dissipation requirement of the electronic device is relatively large, a dual-fan structure may be used, to improve heat dissipation performance of the electronic device.

In a specific embodiment, as shown in FIG. 2, there is an air inlet channel 10 between the upper cover 42 and the rear cover 1. The air inlet channel 10 communicates with the air inlet hole 421.

There is a gap between the upper cover 42 and the rear cover 1, to form the air inlet channel 10. The external low-temperature cold air may flow from the air inlet channel 10 to the air inlet hole 421. Compared with a manner in which the rear cover 1 is provided with a hole as the air inlet channel 10 in the conventional technology, this embodiment ensures integrity and structural strength of the rear cover 1 are not damaged.

In a specific embodiment, at least a part of the convex rib 32 is disposed around the through hole 311. The side panel 44 is fastened to the convex rib 32.

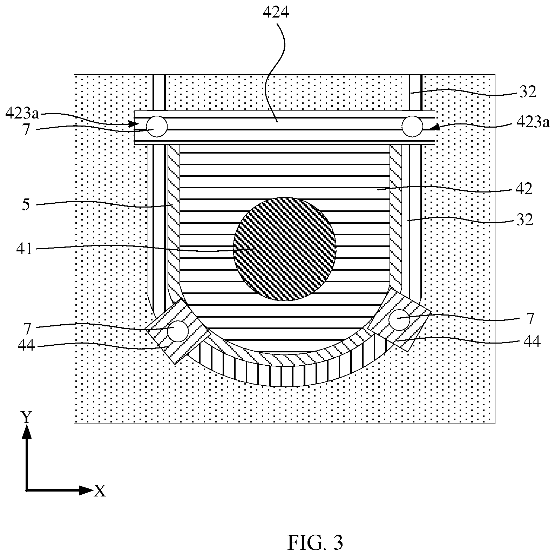

Refer to FIG. 1 and FIG. 3. Apart of the convex rib 32 is disposed around the through hole 311, to form a structure in which the convex rib 32 surrounds the through hole 311 in three sides. In this way, structural strength of the bottom wall 31 around the through hole 311 is enhanced, and a location of the air outlet hole 441 is avoided, ensuring smooth air outlet of the heat dissipation assembly 4. At least a part of the side panel 44 can extend towards a direction close to the convex rib 32, and is stacked on an end portion of the convex rib 32. It is convenient for the convex rib to be fastened to the side panel 44. Specifically, as shown in FIG. 1 and FIG. 3, in a width direction X of the heat dissipation assembly 4, both two sides of the side panel 44 are fastened to the convex rib 32 by using a fastener 7, improving installation stability of the heat dissipation assembly 4.

In addition, as shown in FIG. 3, the other part of the convex rib 32 can extend in a length direction Y of the heat dissipation assembly 4, to improve structural strength at another location of the bottom wall 31, and further improve overall strength of the middle frame 3.

In a specific embodiment, as shown in FIG. 2, the upper cover 42 includes an upper cover diversion portion 422, and the lower cover 43 includes a lower cover diversion portion 431. The upper cover diversion portion 422 and the lower cover diversion portion 431 are disposed opposite to each other in the thickness direction Z of the electronic device.

The upper cover diversion portion 422 and the lower cover diversion portion 431 are disposed opposite to each other in the thickness direction Z of the electronic device, so that a diversion channel can be formed. The diversion channel communicates with the air outlet hole 441, and is configured to guide an airflow flowing from the air outlet hole 441 to the heat generation electronic component, ensuring smooth air outlet of the heat dissipation assembly 4.

Specifically, as shown in FIG. 2, the lower cover 43 further includes a lower cover body 432. The lower cover diversion portion 431 is connected to the lower cover body 432, and is inclined relative to the lower cover body 432 towards a direction close to the upper cover 42; and/or the upper cover 42 further includes an upper cover body 423, and the upper cover diversion portion 422 is connected to the upper cover body 423, and is inclined relative to the upper cover body 423 towards a direction away from the lower cover 43.

The lower cover body 432 and the upper cover body 423 are configured to enclose the accommodation space 45 together with the side panel 44; the lower cover diversion portion 431 approaches the air outlet hole 441, and is configured to guide the airflow at the air outlet hole 441; and specifically, the lower cover diversion portion 431 is inclined relative to the lower cover body 432 towards a direction close to the upper cover 42, and a slope structure is formed, so that the airflow climbs upward along the slope and then flows to the heat generation electronic component, to ensure smooth flow-out of the airflow in the accommodation space 45, and avoid unsmooth air outlet of the heat dissipation assembly 4 due to block of the bottom wall 31; and/or
the upper cover diversion portion 422 approaches a location of the air outlet hole 441, and is configured to cooperate with the lower cover diversion portion 431 for guiding; and specifically, the upper cover diversion portion 422 is inclined relative to the upper cover body 423 towards a direction away from the lower cover 43, and a slope structure is also formed, so that the upper cover diversion portion 422 of the slope structure can increase an air outlet area of the heat dissipation assembly 4 in comparison with a structure extending in a horizontal direction, to increase an air outlet volume, and further improve heat dissipation effect of the heat dissipation assembly 4.

In a specific embodiment, as shown in FIG. 2, there is an included angle α between the lower cover diversion portion 431 and the lower cover body 432. The included angle α meets 120° ≤ α ≤ 170°. The included angle α may be specifically 120°, 130°, 150°, 165°, or 170°, or may be another value within the foregoing range. This is not limited herein.

In this embodiment, if the included angle α is excessively small (for example, is less than 120°), an air outlet area of the heat dissipation assembly 4 is not large enough, and an air outlet volume is excessively small, affecting heat dissipation effect of the heat dissipation assembly 4. If the included angle α is excessively large (for example, is greater than 170°), the lower cover diversion portion 431 approaches being horizontal. A diversion function is excessively small, and it cannot be ensured that the airflow can climb to a height above the bottom wall 31 and flow to the heat generation electronic component. This also affects heat dissipation effect of the heat dissipation assembly 4. Therefore, when the included angle α between the lower cover diversion portion 431 and the lower cover body 432 is 120° to 170°, it can be ensured that air outlet of the heat dissipation assembly 4 is smooth and that the air volume is large enough.

In a specific embodiment, as shown in FIG. 2, the upper cover 42 further includes an upper cover reinforcement portion 424. At least a part of the upper cover body 423 is connected to the upper cover reinforcement portion 424. The upper cover reinforcement portion 424 protrudes towards a direction away from the lower cover 43 relative to the upper cover body 423.

The upper cover reinforcement portion 424 protrudes towards the direction away from the lower cover 43 relative to the upper cover body 423. In this way, a local reinforcement function is implemented, structural strength of the upper cover body 423 connected to the upper cover reinforcement portion 424 is improved. Therefore, strength of the heat dissipation assembly 4 is further improved, improving a pressing resistance capability of the heat dissipation assembly 4.

The upper cover reinforcement portion 424 and the upper cover body 423 may be of an integral structure, or may be of a split structure. This is not limited in this embodiment. A thickness of the upper cover reinforcement portion 424 may be 0.4 mm to 0.8 mm, to ensure that structural strength of the upper cover body 423 is effectively improved. Specifically, the thickness may be 0.4 mm, 0.5 mm, 0.6 mm, or 0.8 mm, or may be another value within the foregoing range. This is not limited herein.

In a specific embodiment, as shown in FIG. 3, connection portions 423a are disposed on the upper cover body 423. The connection portions 423a are connected to the upper cover reinforcement portion 424. In the width direction X of the heat dissipation assembly 4, the connection portions 423a are disposed at two ends of the upper cover body 423. The two connection portions 423a are separately fastened to the convex rib 32.

In this embodiment, the two connection portions 423a are separately fastened to the convex rib 32 in the width direction X of the heat dissipation assembly 4. This can further improve installation stability of the heat dissipation assembly 4. As shown in FIG. 3, the connection portions 423a are connected to the upper cover reinforcement portion 424. The connection portions 423a are connected to the convex rib 32 located on two sides of the heat dissipation assembly 4 to form an annular reinforcement structure as a whole. This can further implement a reinforcement function, and improve structural strength of the middle frame 3. In addition, force applied to the convex rib 32 can be more evenly distributed, improving structural stability of the convex rib 32.

The connection portion 423a may be fastened to the convex rib 32 by using the fastener 7. The fastener 7 may be specifically a screw or another connecting member. This is not limited in this embodiment.

In a specific embodiment, the electronic device further includes a flexible circuit board 6. One end that is of the lower cover 43 and that is away from the fan 41 is provided with a groove. At least a part of the flexible circuit board 6 is disposed in the groove.

One end of the flexible circuit board 6 is connected to the heat dissipation assembly 4, and the other end is connected to the mainboard of the electronic device. As shown in FIG. 1, one end that is of the lower cover 43 and that is away from the fan 41 may be provided with the groove (for example, manufactured through an etching process), and then the flexible circuit board 6 is disposed in the groove, that is, the flexible circuit board 6 is embedded in the bottom wall of the lower cover 43. Compared with a solution in which the flexible circuit board 6 is directly attached to the bottom wall of the lower cover 43 in the conventional technology, this solution can further reduce a thickness of the electronic device, and helps to implement lightness and thinness of the electronic device.

In conclusion, based on the electronic device provided in this embodiment, a thickness of the electronic device can be reduced without affecting heat dissipation effect of the heat dissipation assembly 4, and structural strength of the middle frame 3 is improved by disposing the reinforcement member 5 and the upper cover reinforcement portion 424. Therefore, reliability of the heat dissipation assembly 4 and the screen 2 is improved, and that the fan 41 and the screen 2 do not fail when the electronic device is used is ensured.

The foregoing descriptions are merely specific implementations of embodiments of this application, but are not intended to limit the protection scope of embodiments of this application. Any variation or replacement within the technical scope disclosed in embodiments of this application shall fall within the protection scope of embodiments of this application. Therefore, the protection scope of embodiments of this application shall be subject to the protection scope of the claims.

## Claims

1. An electronic device, wherein the electronic device comprises:
a rear cover;
a screen;
a middle frame, wherein the middle frame is located between the rear cover and the screen, the middle frame comprises a fastened bottom wall and a fastened convex rib, the bottom wall is provided with a through hole, the convex rib is located on an outer side of the through hole, and the convex rib protrudes in a thickness direction of the electronic device and towards a direction away from the bottom wall; and
a heat dissipation assembly, wherein the heat dissipation assembly is disposed on the convex rib, and at least a part of the heat dissipation assembly is located in the through hole.

2. The electronic device according to claim 1, wherein the electronic device further comprises a reinforcement member, the reinforcement member is fastened at one end that is of the bottom wall and that is away from the convex rib, and the reinforcement member covers the through hole.

3. The electronic device according to claim 1, wherein the heat dissipation assembly comprises a housing and a fan, the housing comprises an upper cover, a lower cover, and a side panel, the upper cover, the lower cover, and the side panel jointly enclose an accommodation space, the fan is disposed in the accommodation space, the upper cover is provided with an air inlet hole, the side panel is provided with an air outlet hole, and the air inlet hole and the air outlet hole separately communicate with the accommodation space.

4. The electronic device according to claim 3, wherein there is an air inlet channel between the upper cover and the rear cover, and the air inlet channel communicates with the air inlet hole.

5. The electronic device according to claim 3, wherein at least a part of the convex rib is disposed around the through hole, and the side panel is fastened to the convex rib.

6. The electronic device according to claim 3, wherein the upper cover comprises an upper cover diversion portion, the lower cover comprises a lower cover diversion portion, and the upper cover diversion portion and the lower cover diversion portion are disposed opposite to each other in the thickness direction of the electronic device.

7. The electronic device according to claim 6, wherein the lower cover further comprises a lower cover body, and the lower cover diversion portion is connected to the lower cover body and is inclined relative to the lower cover body towards a direction close to the upper cover; and/or
the upper cover further comprises an upper cover body, and the upper cover diversion portion is connected to the upper cover body, and is inclined relative to the upper cover body towards a direction away from the lower cover.

8. The electronic device according to claim 7, wherein there is an included angle α between the lower cover diversion portion and the lower cover body, and the included angle α meets 120° ≤ α ≤ 170°.

9. The electronic device according to claim 7, wherein the upper cover further comprises an upper cover reinforcement portion, at least a part of the upper cover body is connected to the upper cover reinforcement portion, and the upper cover reinforcement portion protrudes relative to the upper cover body towards a direction away from the lower cover.

10. The electronic device according to claim 9, wherein connection portions are disposed on the upper cover body, the connection portions are connected to the upper cover reinforcement portion, in a width direction of the heat dissipation assembly, the connection portions are disposed at two ends of the upper cover body, and the two connection portions are separately fastened to the convex rib.

11. The electronic device according to any one of claims 3 to 10, wherein the electronic device further comprises a flexible circuit board, one end that is of the lower cover and that is away from the fan is provided with a groove, and at least a part of the flexible circuit board is disposed in the groove.
